Europäisches Patentamt

(19) European Patent Office

Office européen des brevets

(11) Veröffentlichungsnummer: **0 060 924**
**B1**

(12) **EUROPÄISCHE PATENTSCHRIFT**

(45) Veröffentlichungstag der Patentschrift:
20.03.85

(51) Int. Cl.⁴: **G 01 R 31/28**

(21) Anmeldenummer: 81108736.0

(22) Anmeldetag: 22.10.81

(54) **Selektives Logikbild von Informationsgruppen auf mehreren zusammengehörenden Knoten einer integrierten Schaltung.**

(30) Priorität: 16.03.81 DE 3110139

(43) Veröffentlichungstag der Anmeldung:
29.09.82 Patentblatt 82/39

(45) Bekanntmachung des Hinweises auf die Patenterteilung:
20.03.85 Patentblatt 85/12

(84) Benannte Vertragsstaaten:
DE FR GB NL

(56) Entgegenhaltungen:
DE - A - 2 813 948

Beitr. elektronenmikroskop. Direktabb. Oberfl. 11 (1978), S. 67-71
Beitr. elektronenmikroskop Direktabb. Oberfl. 8 (1975) S. 469-480
Scanning Electron Microscopy 1978 vol. I S. 375-380
Digest of papers 1980 IEEE Test Conference S. 444-449
IEEE JOURNAL OF SOLID STATE CIRCUITS Vol. SC 14, No. 2, April 1979 E. WOLFGANG et al. "Electron-Beam Testing of VLSI Circuits" Seiten 471 bis 481

(73) Patentinhaber: Siemens Aktiengesellschaft, Berlin und München Wittelsbacherplatz 2, D-8000 München 2 (DE)

(72) Erfinder: Fazekas, Peter, Dipl.-Ing., Stuntzstrasse 21, D-8000 München 80 (DE)

## Beschreibung

Die Erfindung betrifft ein Verfahren zur Prüfung einer programmgesteuerten integrierten Schaltung nach dem Oberbegriff des Anspruchs 1.

Bei der Prüfung komplexer logischer Schaltungen ist es oft nötig, die internen Abläufe an Hand von Informationsflüssen auf zusammengehörenden Knoten, wie internen Bussen, internen Registern oder Steuerleitungen, zu überprüfen.

Nach dem Stand der Technik können die internen Busse entweder durch Messungen mit mechanischen Messspitzen oder durch stroboskopische Abbildungsverfahren wie dem Logikbild (G. Crichton et al: «Electron Beam Testing of Microprocessors», Digest of Papers 1980, IEEE Test Conference, pp. 444-449, 1980) mit einem Raster-Elektronenmikroskop überprüft werden.

Bei hochintegrierten Schaltungen können mit mechanischen Messspitzen Informationsflüsse auf zusammengehörenden internen Knoten nicht gleichzeitig überprüft werden. Im Logikbild (oder «logic state mapping») werden sämtliche Zustandsänderungen des abgebildeten Busses innerhalb eines bestimmten Zeitbereiches erfasst. Soll beispielsweise lediglich der Inhalt eines internen Festwertspeichers überprüft werden, dann liefert diese Abbildungsmethode nicht nur den Inhalt dieses internen Festwertspeichers, sondern zusätzlich eine Informationsfülle (Adressen, Flags, usw.), aus der erst mühsam die gewünschten Daten, in diesem Fall der Inhalt eines internen Festwertspeichers, selektiert werden müssen.

Aus «IEEE J. Solid-State Circuits», Vol. SC 14, No. 2, 1979, Seiten 471-481, insbesondere Kap. II.B.4), ist ein stroboskopisches Abbildungsverfahren des Potentialkontrastes bei einer integrierten Schaltung bekannt. Dabei wird die integrierte Schaltung mittels einer Programmschleife zyklisch angesteuert. Synchron mit dem zyklischen Ablauf dieser Programmschleife wird entweder die Nachweiselektronik oder der Elektronenstrahl periodisch getastet. Die Phasenlage bezüglich der Programmschleife, zu der entweder der Elektronenstrahl oder die Nachweiselektronik getastet werden, wird dabei gesteuert. Diese Steuerung erfolgt üblicherweise so, dass die Phasenlage der Austastpulse bezüglich der Programmschleife kontinuierlich über die gesamte Programmschleife geschoben wird. Dabei werden sämtliche Zustandsänderungen der abgebildeten Schaltungsknoten innerhalb eines bestimmten Zeitbereiches erfasst.

Der Erfindung liegt die Aufgabe zugrunde, ein Verfahren der eingangs genannten Art anzugeben, mit dem eine selektive Abbildung bestimmter Informationsgruppen möglich ist.

Erfindungsgemäss wird diese Aufgabe durch ein Verfahren nach dem Anspruch 1 gelöst.

Sollen bestimmte Speicherinhalte selektiv abgebildet werden, so werden die zu den betreffenden Knoten gehörenden Speicherzellen durch die Programmschleife so oft ausgelesen, dass die einzelnen Speicherbits während der Abrasterung des Bildschirms als Balken dargestellt werden.

Ein spezielles Ausführungsbeispiel der Erfindung ist in der Zeichnung dargestellt und wird im folgenden näher beschrieben.

Fig. 1 zeigt ein Detail des Steuerprogramms der nach dem erfindungsgemässen Verfahren geprüften integrierten Schaltung.

Fig. 2 zeigt eine Abbildung des Inhalts eines Speicherbereiches.

Die im folgenden beschriebene Technik baut auf einer früheren Arbeit von Feuerbaum: «Beiträge zu Fortschritten in der Elektronenstrahl-Messtechnik», Beiträge elektronenmikroskopischer Direktabbildungen Oberfl. 11, 67-71, 1978, auf. Die experimentellen Untersuchungen wurden an einem unpassivierten 8085 Mikroprozessor durchgeführt, der in einer geschrumpften Version bei Siemens entwickelt und hergestellt wurde.

Die meisten integrierten Schaltungen müssen dynamisch geprüft werden, d.h. sie müssen während der Untersuchung mit Nennfrequenz arbeiten. Unter Ausnützung des Stroboskopieeffektes können auch solche Schaltkreise quasistatisch im Potentialkontrast abgebildet werden. Um dies zu erreichen, wird die zu untersuchende komplexe logische Schaltung mit sich zyklisch wiederholenden Signalen angesteuert und im Raster-Elektronenmikroskop abgebildet. Der Elektronenstrahl wird in jedem Zyklus nur einmal für kurze Zeit eingeschaltet, d.h. die Probe wird nur während einer bestimmten Phase betrachtet. Die Abbildung ist somit eine Momentaufnahme der schnell arbeitenden komplexen logischen Schaltung. Der Einschaltzeitpunkt des Elektronenstrahles kann innerhalb des Zyklus beliebig gewählt werden. Die Einschaltdauer des Elektronenstrahls kann bis zum Picosekundenbereich reduziert werden, d.h. die Zeitauflösung dieses Abbildungsverfahrens liegt im Picosekundenbereich.

Um ein selektives Logikbild zu erstellen, tastet die gepulste Elektronensonde die zusammengehörenden Knoten langsam in x-Richtung ab, beginnend beim ersten Knoten und endend beim letzten Knoten. Ist die Elektronensonde beim letzten Konten angelangt, springt sie zum ersten Knoten zurück und der Vorgang beginnt von neuem. Während die Elektronensonde auf der integrierten Schaltung stets dieselbe Strecke in x-Richtung abtastet, rastert der Elektronenstrahl am zugehörigen Bildschirm des Raster-Elektronenmikroskops diesen Bildschirm Zeile für Zeile ab, so dass auf diesem Bildschirm ein flächenhaftes Bild entsteht. Die Phase der gepulsten Elektronensonde, welche den Einschaltzeitpunkt der Elektronensonde bezüglich des Triggersignals der Ansteuerung der zu prüfenden komplexen logischen Schaltung definiert, wird so festgelegt, dass die Elektronensonde die zusammengehörenden Knoten nur zu den Zeitpunkten abtastet, zu denen das Bit-Muster einer bestimmten Information an diesen zusammengehörenden Knoten anliegt.

Gleichzeitig mit dem Zeilenvorschub am Bildschirm des Raster-Elektronenmikroskopes in y-Richtung kann die Phase der Elektronenpulse je nach dem, wo im Zyklus der zu prüfenden komplexen logischen Schaltung die zu überprüfende Informationsgruppe auftaucht, konstant gehalten oder verändert werden. Durch den frei wählbaren Phasenbereich während eines Bilddurchlaufes können beliebige Teile einer Programmschleife im selektiven Logikbild dargestellt werden. Die Abbildung der logischen Zustände erfolgt dabei durch den Potentialkontrast: Logisch «0» erscheint hell und logisch «1» erscheint dunkel (H.-P. Feuerbaum et al: «Qualitative and quantative voltage measurement on integrated circuits», Beiträge elektronenmikroskopischer Direktabbildungen Oberfl., vol. 8, pp. 469-480, 1975 und A. Gopinath et al, «Voltage contrast: A Review», SEM/1978 pp. 375-380).

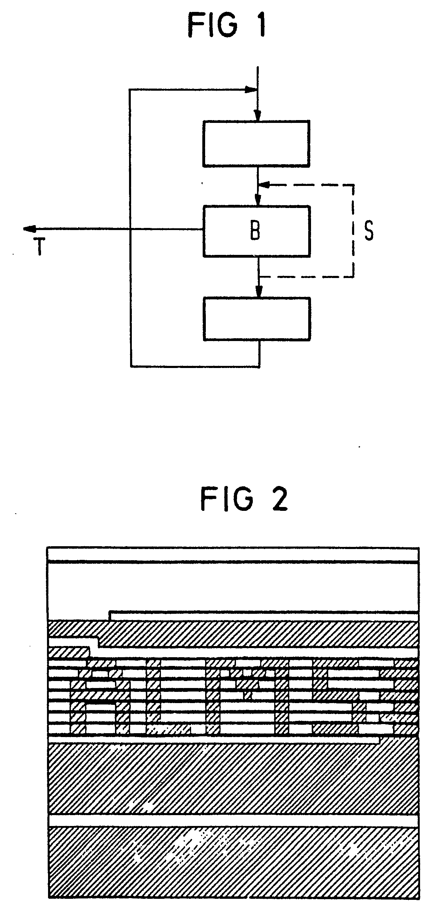

Figur 1 zeigt eine Softwaremassnahme an einem Prüfling, mit der erreicht wird, dass ein zu überprüfendes Bit-Muster an zusammengehörenden Knoten beliebig oft anliegt, so dass während der Abrasterung des Bildschirmes ein zu überprüfendes Bit-Muster selektiv als Balken abgebildet werden kann. In der zu prüfenden komplexen logischen Schaltung wird ein Programm abgearbeitet, in das eine Schleife S eingefügt ist, welche den Befehl B: «Speicherzelle lesen» aufweist. Diese Schleife S wird n-mal durchlaufen, wobei die Elektronensonde während des Lesens einer Speicherzelle durch den Trigger T für das Strahltastsystem der Elektronensonde ebenfalls n-mal eingetastet wird, und zwar mit einer solchen Phase, dass bei Ausführung des Befehls «Speicherzelle lesen» nur der Inhalt der infolge dieses Befehls ausgelesenen Speicherzelle auf dem Bildschirm des Raster-Elektronenmikroskops abgebildet wird.

Figur 2 zeigt eine erfindungsgemässe Abbildung eines Speicherbereiches. Die Bit-Muster der abgebildeten Speicherinhalte wurden dabei so gewählt, dass der im selektiven Logikbild wiedergegebene Speicherinhalt als Zeichenfolge ALM 5 erscheint. Bei einem 8085 Mikroprozessor wird ein Lesebefehl in etwa 5 $\mu$sec ausgeführt. Da bei der Erstellung der Abbildung des Inhaltes eines Speicherbereiches gemäss Figur 2 die Lesebefehle alle dieselbe Ablaufstruktur aufweisen, musste für jeden neuen Bild-Abschnitt (für jedes neue Bit-Muster) eine neue Speicherzelle ausgelesen werden, die Phase der Elektronensonde während eines jeden Lesebefehls konnte jedoch konstant gehalten werden. Bei der Erstellung des Bildes von Figur 2 wurde eine Pulsbreite der Elektronensonde von 50 ns angewandt. Bei der Erstellung eines jeden Bildabschnittes des Bildes von Figur 2 wurde in einer Schleife die zugehörige Speicherzelle so oft ausgelesen, dass jeder einzelne Bildabschnitt eine Breite von etwa 5 mm aufweist. Die Erstellung des Bildes von Figur 2 beanspruchte eine Zeit von etwa 100 sec.

In der zeitlichen Abfolge eines Lesebefehls taucht der Inhalt einer Speicherzelle immer wieder zeitlich gesehen an derselben Stelle auf. Die Phase, mit der die Elektronensonde die bezüglich der Triggerung der Ansteuerung der zu prüfenden Schaltung zusammengehörenden Knoten erfindungsgemäss abtasten muss, um ein selektives Logikbild zu erhalten, kann bei jedem Lesebefehl auch bei verschiedenem Inhalt von verschiedenen Speicherzellen konstant gehalten werden. Die Erfindung ist jedoch nicht auf die Selektion von Daten aus ein- und dieselbe Struktur aufweisenden Befehlen beschränkt. Vielmehr kann bei unterschiedlichen Befehlsstrukturen die Phase der Elektronensonde auch jeweils so angepasst werden, dass nur die gewünschte Information auf dem Bildschirm des Raster-Elektronenmikroskops abgebildet wird.

Ein selektives Logikbild kann mittels eines modifizierten Raster-Elektronenmikroskops (Etec-Autoscan) (E. Wolfgang et al, «internal testing of microprocessor chips using electron beam techniques», Proceedings of IEEE International Conf. on circuits and computers 1980, pp. 548-551, 1980) erzeugt werden. Der Ablauf der Messung wird von einem Rechner gesteuert (Interdata 6/16). Die Phasensteuerung erfolgt über einen D/A-Wandler und einen Verzögerungsgenerator, die Positionierung der zusammengehörenden Knoten erfolgt mittels eines digitalen Rastergenerators.

**Patentansprüche**

1. Verfahren zur Prüfung einer programmgesteuerten integrierten Schaltung, bei dem
— die zusammengehörende Daten repräsentierenden logischen Zustände mehrerer Schaltungsknoten während der zyklisch wiederholten Abarbeitung einer Programmschleife jeweils zu bestimmten Zeitpunkten mittels des mit der Wiederholfrequenz der Programmschleife gepulsten Elektronenstrahls eines Raster-Elektronenmikroskops stroboskopisch abgetastet werden, wobei die Phasenlage der Elektronenpulse bezüglich der Programmschleife gesteuert wird,
— das erhaltene Abtastsignal auf einem Bildschirm mit Zeilenraster dargestellt wird, dadurch gekennzeichnet, dass
— die betreffenden Schaltungsknoten wiederholt in der gleichen Reihenfolge abgetastet werden, und
— die Phasenlage der Elektronenpulse bezüglich des Triggersignals der Ansteuerung der zu prüfenden Schaltung so festgelegt wird, dass die betreffenden Knoten nur zu den Zeitpunkten abgetastet werden, zu denen das Bit-Muster einer bestimmten Information an diesen Knoten anliegt.

2. Verfahren nach Anspruch 1, dadurch gekennzeichnet, dass im Falle der Prüfung einer integrierten Speicherschaltung die zu den betreffenden Knoten gehörenden Speicherzellen durch die Programmschleife so oft ausgelesen werden, dass die einzelnen Speicherbits während der Abrasterung des Bildschirms als Balken dargestellt werden.

**Claims**

1. A method of testing a programme-controlled integrated circuit, wherein:
— items of data represented by the logic states of a plurality of associated circuit nodes are each scanned stroboscopically during the cyclically repeated processing of a programme loop at specific times by means of the electron beam of a scanning electron microscope which is pulsed at the repetition frequency of the programme loop, to control the phase position of the electron pulses relative to the programme loop;

— the scanning signal which is obtained is represented on a screen with a line raster pattern, characterised in that

— the relevant circuit nodes are scanned repeatedly in the same sequence; and

— the phase position of the electron pulses relative to the trigger signal of the drive means of the circuit to be tested is such that the relevant nodes are scanned only at the times at which the bit pattern of a specific item of information is applied to this node.

2. A method as claimed in claim 1, characterised in that when an integrated storage circuit is to be tested the storage cells assigned to the relevant nodes are read out by the programme loop sufficiently often to enable the individual bits to be represented as bands during the signal rastering of the viewing screen.

## Revendications

1. Procédé pour contrôler un circuit intégré commandé par programme, selon lequel

— les états logiques, représentant des données associées, de plusieurs noeuds du circuit sont explorés par voie stroboscopique respectivement à des instants déterminés, pendant l'exécution répétée de façon cyclique d'une boucle de programme, au moyen du faisceau électronique, commandé de façon impulsionnelle à la fréquence de répétition de la boucle de programme, d'un microscope électronique à balayage, la position de phase des impulsions électroniques par rapport à la boucle de programme étant commandée,

— le signal d'exploration obtenu est représenté sur l'écran avec une trame de lignes, caractérisé par le fait que

— les noeuds considérés du circuit sont explorés de façon répétée dans le même ordre, et

— la position de phase des impulsions électroniques par rapport au signal de déclenchement de la commande du circuit devant être contrôlé est fixée en sorte que les noeuds considérés ne sont explorés qu'aux instants auxquels le profil binaire d'une information déterminée est appliqué à ces noeuds.

2. Procédé suivant la revendication 1, caractérisé par le fait que dans le cas du contrôle d'un circuit de mémoire intégré, les cellules de mémoire faisant partie des noeuds considérés sont lues par la boucle de programme suffisamment souvent pour que les différents bits de mémoire soient représentés sous la forme de traits pendant le balayage de l'écran.

# FIG 1

# FIG 2